(19) Europäisches Patentamt
European Patent Office
Office européen des brevets

(11) EP 4 746 651 A1

(12) **EUROPEAN PATENT APPLICATION**
published in accordance with Art. 153(4) EPC

(43) Date of publication:
**20.05.2026 Bulletin 2026/21**

(21) Application number: **24839546.9**

(22) Date of filing: **28.06.2024**

(51) International Patent Classification (IPC):
***H10K 30/60*** *(2023.01)* ***H10F 39/12*** *(2025.01)*
***H10K 30/40*** *(2023.01)* ***H10K 39/32*** *(2026.01)*

(52) Cooperative Patent Classification (CPC):
**H10K 30/35; C09K 11/02; C09K 11/025; C09K 11/62; H10K 30/40; H10K 30/60; H10K 39/32; H10K 71/15; H10K 85/215;**
C09K 2211/188; H10K 30/85; H10K 30/86; H10K 71/40

(86) International application number:
**PCT/JP2024/023471**

(87) International publication number:
**WO 2025/013654 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.07.2023 JP 2023114051**

(71) Applicant: **FUJIFILM Corporation**
**Tokyo 106-8620 (JP)**

(72) Inventors:
- **TABUCHI, Atsuko**
**Haibara-gun, Shizuoka 421-0396 (JP)**
- **SAWAMURA, Yasuhiro**
**Haibara-gun, Shizuoka 421-0396 (JP)**
- **GOTO, Takashi**
**Haibara-gun, Shizuoka 421-0396 (JP)**

(74) Representative: **HGF**
**HGF Limited**
**4th Floor, 1 City Square**
**Leeds LS1 2ES (GB)**

(54) **DISPERSION LIQUID, METHOD FOR PRODUCING QUANTUM DOT FILM, METHOD FOR PRODUCING LIGHT DETECTION ELEMENT, AND METHOD FOR PRODUCING IMAGE SENSOR**

(57) There is provided a dispersion liquid including quantum dots, a ligand, and a solvent, in which the solvent includes at least one selected from a compound represented by Formula (1) or a polycyclic ketone compound, and a content of the quantum dots in a component obtained by removing the solvent and the ligand from the dispersion liquid is 50% by mass or more. There are also provided methods for manufacturing a quantum dot film using the dispersion liquid described above, a photodetector, and an image sensor.

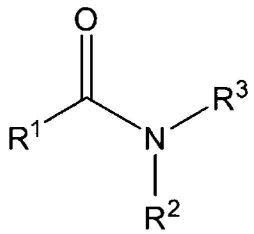

(1)

EP 4 746 651 A1

## Description

## BACKGROUND OF THE INVENTION

1. Field of the Invention

The present invention relates to a dispersion liquid containing quantum dots. In addition, the present invention relates to a method for manufacturing a quantum dot film, a method for manufacturing a photodetector, and a method for manufacturing an image sensor.

2. Description of the Related Art

In recent years, attention has been focused on photodetectors capable of detecting light in an infrared region in the fields such as smartphones, surveillance cameras, and in-vehicle cameras.
In the related art, a silicon photodiode in which a silicon wafer is used as a material of a photoelectric conversion film has been used in a photodetector that is used for an image sensor or the like. However, a silicon photodiode has low sensitivity in the infrared region having a wavelength of 900 nm or more.
In addition, an InGaAs-based semiconductor material known as a near-infrared light-receiving element has a problem in that it requires extremely high-cost processes such as epitaxial growth or a step of bonding a substrate in order to realize a high quantum efficiency, and thus it has not been widely adopted.
In addition, in recent years, the use of the quantum dot for a photoelectric conversion element has been being studied. For example, Patent Literature 1 describes that quantum dots containing inorganic particles are used for a photoelectric conversion film of a photoelectric conversion element, where the quantum dots have organic ligands and inorganic ligands on their surfaces, and a molar ratio of the inorganic ligands to a total of the inorganic ligands and the organic ligands is 25% or more and 99.8% or less.

2. Citation List

Patent Literature

Patent Literature 1 JP2020-150251A

## SUMMARY OF THE INVENTION

In the related art, a ligand having a long molecular chain length, such as oleic acid, has been used in a dispersion liquid containing quantum dots. In JP2020-150251A, a ligand having a long molecular chain length, such as oleic acid, is also used in the dispersion liquid of the quantum dots.
However, in a case where a quantum dot film such as the photoelectric conversion film is formed by using a dispersion liquid containing such a ligand having the long molecular chain length, a distance between the quantum dots tends to be long, sufficient optical response is not obtained, and thus the external quantum efficiency tends to be low. Therefore, after forming a film using a dispersion liquid of quantum dots, a ligand solution is applied onto the film to exchange the ligand coordinated to the quantum dots in the film with another ligand. Also in JP2020-150251A, after forming a film using a dispersion liquid of quantum dots, a ligand solution is applied onto the film to exchange the ligand.
In recent years, it has also been considered to use a ligand having a short molecular chain length in the dispersion liquid of the quantum dots. However, in a case where a ligand having a short molecular chain length is used, the dispersion liquid tends to have a tendency to reduce the dispersibility of the quantum dots in the dispersion liquid. Therefore, in recent years, further improvement in performance has been required for the dispersibility of the dispersion liquid.
In addition, in a case where the dispersion liquid containing the quantum dots has a thickness unevenness, an absorbance of the film changes, which leads to performance unevenness. In order to obtain certain performance, it is required to form a quantum dot film having a smaller thickness unevenness.
Therefore, an object of the present invention is to provide a dispersion liquid that enables formation of a quantum dot film having excellent dispersibility and small thickness unevenness. In addition, another object of the present invention is to provide a method for manufacturing a quantum dot film, a method for manufacturing a photodetector, and a method for manufacturing an image sensor.
The present invention provides the following aspects.

<1> A dispersion liquid comprising:

quantum dots;
a ligand; and
a solvent,
in which the solvent includes at least one selected from a compound represented by Formula (1) or a polycyclic ketone compound, and
a content of the quantum dots in a component obtained by removing the solvent and the ligand from the dispersion liquid is 50% by mass or more,

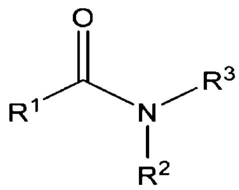

(1)

in Formula (1), $R^1$ represents a hydrogen atom or a substituent having 1 to 10 carbon atoms,
$R^2$ and $R^3$ each independently represent a hydrogen atom or a substituent having 1 to 10 carbon atoms, and two or more of $R^1$, $R^2$, and $R^3$ may be bonded to each other to form a ring structure,
where, in a case where $R^1$ is a hydrogen atom, at least one of $R^2$ or $R^3$ is a substituent having 2 or more carbon atoms.

<2> The dispersion liquid according to <1>, in which the solvent includes the compound represented by Formula (1), and $R^1$ in Formula (1) is a substituent having 2 to 10 carbon atoms and including an ether bond.
<3> The dispersion liquid according to <1>, in which the solvent includes the compound represented by Formula (1), and $R^1$ in Formula (1) is a group represented by Formula (R-1),

$-R^{11}-R^{12}$ ··· (R-1),

in Formula (R-1), $R^{11}$ represents an alkylene group, $R^{12}$ represents an alkoxy group, and the total number of carbon atoms in $R^{11}$ and $R^{12}$ is 2 to 10.
<4> The dispersion liquid according to <1>, in which the solvent includes the compound represented by Formula (1), and $R^1$ and $R^2$ in Formula (1) are bonded to each other to form a ring structure.
<5> The dispersion liquid according to <1>, in which the solvent includes the polycyclic ketone compound, and the polycyclic ketone compound includes a 5- to 7-membered ring structure having an oxygen atom as an atom constituting a ring.
<6> The dispersion liquid according to <1>, in which the solvent includes at least one selected from 3-methoxy-N,N-dimethylpropanamide, 3-butoxy-N,N-dimethylpropanamide, dihydrolevoglucosenone, or 1-butylpyrrolidin-2-one.
<7> The dispersion liquid according to any one of <1> to <6>, in which a content of the quantum dots in the component obtained by removing the solvent and the ligand from the dispersion liquid is 90% by mass or more.
<8> The dispersion liquid according to any one of <1> to <7>, in which the quantum dots contain at least one atom selected from Ga, Ge, P, As, Se, In, Sn, Sb, Te, Pb, Bi, Ag, Cu, or Hg.
<9> The dispersion liquid according to any one of <1> to <7>, in which the quantum dots contain at least one atom selected from P, As, Sb, or In.
<10> The dispersion liquid according to any one of <1> to <9>, in which the quantum dots have a band gap of 1.35 eV or less.
<11> The dispersion liquid according to any one of <1> to <10>, in which the quantum dots have a maximal absorption in terms of absorbance in a wavelength range of 900 to 1,700 nm.
<12> The dispersion liquid according to any one of <1> to <11>, in which the ligand includes at least one selected from an inorganic ligand or a compound having 7 or less carbon atoms.
<13> A method for manufacturing a quantum dot film, comprising:

a step of applying the dispersion liquid according to any one of <1> to <12> onto a support to form a composition layer; and
a step of drying the composition layer.

<14> A method for manufacturing a photodetector, comprising:
performing the method for manufacturing a quantum dot film according to <13>.
<15> A method for manufacturing an image sensor, comprising:

performing the method for manufacturing a quantum dot film according to <13>.

The present invention can provide a dispersion liquid that enables formation of a quantum dot film having excellent dispersibility and small thickness unevenness. In addition, the present invention can provide a method for manufacturing a quantum dot film, a method for manufacturing a photodetector, and a method for manufacturing an image sensor.

## BRIEF DESCRIPTION OF THE DRAWING

FIG. 1 is a view illustrating an embodiment of a photodetector.

## DESCRIPTION OF THE PREFERRED EMBODIMENTS

Hereinafter, the details of the present invention will be described.

In the present specification, "to" is used to mean that numerical values described before and after "to" are included as a lower limit value and an upper limit value, respectively.

In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

<Dispersion Liquid>

A dispersion liquid according to the embodiment of the present invention is a dispersion liquid containing quantum dots, a ligand, and a solvent,

in which the solvent includes at least one selected from a compound represented by Formula (1) or a polycyclic ketone compound, and
a content of the quantum dots in a component obtained by removing the solvent and the ligand from the dispersion liquid is 50% by mass or more.

The dispersion liquid according to the embodiment of the present invention can form a quantum dot film having excellent dispersibility and small thickness unevenness. The reason for obtaining such an effect is presumed as follows. The dispersion liquid according to the embodiment of the present invention includes at least one selected from a compound represented by Formula (1) or a polycyclic ketone compound as a solvent. These solvents have high affinity with the quantum dots and can improve the dispersibility of the quantum dots. Therefore, the dispersion liquid according to the embodiment of the present invention has excellent dispersibility. In addition, it is presumed that, since the solvent has a moderately high boiling point, drying unevenness during application can be suppressed, and since the drying rate is moderately slow, the quantum dots can be arranged at a higher density during film formation. Therefore, it is presumed that, by using the dispersion liquid according to the embodiment of the present invention, a quantum dot film having small thickness unevenness can be formed.

The quantum dot film obtained by using the dispersion liquid according to the embodiment of the present invention has a high external quantum efficiency and a small dark current because the quantum dots are arranged at a high density and the thickness unevenness is small. Therefore, the quantum dot film obtained by using the dispersion liquid according to the embodiment of the present invention can be used in a photodetector or an image sensor. More specifically, the quantum dot film can be used for a photoelectric conversion film of a photodetector or an image sensor. Therefore, the dispersion liquid according to the embodiment of the present invention is preferably used for a photoelectric conversion film of a photodetector or an image sensor.

Hereinafter, the dispersion liquid according to the embodiment of the present invention will be described in more detail.

(Quantum Dots)

The dispersion liquid according to the embodiment of the present invention contains quantum dots. The quantum dots are preferably a semiconductor particle including a metal atom. Furthermore, in the present specification, the metal atom also includes a metalloid atom typified by an Si atom. In addition, the "semiconductor" in the present specification means a substance having a specific resistance value of $10^{-2}$ Ωcm or more and $10^{8}$ Ωcm or less.

Examples of the quantum dot material constituting the quantum dot include nanoparticles (a particle having a size of 0.5 nm or more and less than 100 nm) of general semiconductor crystals [a) a Group IV semiconductor, b) a compound semiconductor of Group IV-IV, Group III-V, or Group II-VI, or c) a compound semiconductor consisting of a combination of three or more of a Group II element, a Group III element, a Group IV element, a Group V element, and a Group VI element].

The quantum dot preferably includes at least one kind of atom selected from Ga, Ge, P, As, Se, In, Sn, Sb, Te, Pb, Bi, Ag, Cu, or Hg, more preferably includes at least one kind of atom selected from Ga, P, As, Se, In, Sb, Te, or Bi, and still more preferably includes at least one kind of atom selected from P, As, Sb, or In.

The quantum dots containing Pb atoms are exemplified as a preferred aspect of the quantum dots.

Another preferred aspect of the quantum dots is quantum dots containing In atoms. The quantum dots in the present aspect are preferably quantum dots containing In atoms and at least one atom selected from Sb atoms or As atoms.

Another preferred aspect of the quantum dots is quantum dots containing Ag atoms and Bi atoms.

Specific examples of the quantum dot material constituting the quantum dots include semiconductor materials having a relatively narrow band gap, such as PbS, PbSe, PbSeS, InN, Ge, InAs, InGaAs, CuInS, CuInSe, CuInGaSe, InSb, HgTe, HgCdTe, $Ag_2S$, $Ag_2Se$, $Ag_2Te$, SnS, SnSe, SnTe, Si, InP, $AgBiS_2$, and AgBiSTe. Due to the reason that the absorption coefficient of light in the infrared region is large, the lifetime of photocurrent is long, the carrier mobility is large, and the like, the quantum dots are preferably PbS, InAs, InSb, InAsSb, or InPAs.

A band gap of the quantum dots is preferably 1.35 eV or less, more preferably 1.1 eV or less, and still more preferably 1.0 eV or less. A lower limit value of the band gap of the quantum dots is not particularly limited, but can be 0.5 eV or more. In a case where the band gap of the quantum dots is 1.35 eV, it is possible to form a quantum dot film having a higher external quantum efficiency with respect to light having a wavelength in the infrared region. The band gap of the quantum dots can be calculated from the energy at the maximal absorption wavelength in an absorption spectrum obtained from light absorption measurement in a range from the visible region to the infrared region, by using an ultraviolet-visible-near infrared spectrophotometer. In addition, it can be determined from a Tauc plot as described in JP5949567B in a case of quantum dots having no maximal absorption wavelength.

The quantum dots are preferably quantum dots that have a maximal absorption in terms of absorbance in a wavelength range of 900 to 1,700 nm, and it is more preferably such one that has a maximal absorption in terms of absorbance in a wavelength range of 1,300 to 1,600 nm. In a case where such quantum dots are used, it is possible to form a quantum dot film having a higher external quantum efficiency with respect to light having a wavelength in the infrared region.

The quantum dots are also preferably quantum dots that have high absorption with respect to light having any wavelength in a wavelength range of 900 to 1,700 nm (preferably, a wavelength range of 1,300 to 1,600 nm). In a case where such quantum dots are used, it is possible to form a quantum dot film having a higher external quantum efficiency with respect to light having a wavelength in the infrared region.

The average particle diameter of the quantum dots is preferably 3 to 20 nm. The lower limit value of the average particle diameter of the quantum dots is preferably 4 nm or more and more preferably 5 nm or more. The upper limit value of the average particle diameter of the quantum dots is preferably 15 nm or less and more preferably 10 nm or less. In a case where the average particle diameter of the quantum dots is in the above-described range, it is possible to form a quantum dot film having a higher external quantum efficiency with respect to light having a wavelength in the infrared region. It is noted that in the present specification, the value of the average particle diameter of the quantum dots is an average value of the particle diameters of ten quantum dots which are randomly selected. A transmission electron microscope may be used for measuring the particle diameter of the quantum dots.

The content of the quantum dots in the dispersion liquid is preferably 1% to 25% by mass with respect to the total mass of the dispersion liquid. The lower limit thereof is preferably 2% by mass or more and more preferably 3% by mass or more. The upper limit thereof is preferably 20% by mass or less.

In addition, the content of the quantum dots in the dispersion liquid is preferably 10 to 250 mg/mL. The lower limit thereof is preferably 20 mg/mL or more, and more preferably 30 mg/mL or more. The upper limit thereof is preferably 200 mg/mL or less.

In addition, the content of the quantum dots in the component obtained by removing the solvent and the ligand from the dispersion liquid is 50% by mass or more, preferably 60% by mass or more, more preferably 70% by mass or more, still more preferably 80% by mass or more, even more preferably 90% by mass or more, and particularly preferably 95% by mass or more. The upper limit thereof may be 100% by mass or less.

In addition, the total content of the quantum dots and the ligand in the component obtained by removing the solvent from the dispersion liquid is preferably 60% by mass or more, more preferably 70% by mass or more, still more preferably 80% by mass or more, even more preferably 90% by mass or more, and particularly preferably 95% by mass or more. The upper limit thereof may be 100% by mass or less.

(Ligand)

The dispersion liquid according to the embodiment of the present invention contains a ligand. The ligand may be an organic ligand or an inorganic ligand. An inorganic ligand and an organic ligand can be used in combination.

The inorganic ligand is preferably an inorganic halide. Examples of the halogen atom contained in the inorganic halide include a fluorine atom, a chlorine atom, a bromine atom, and an iodine atom, a bromine atom or an iodine atom is preferable, and a bromine atom is more preferable. In addition, the inorganic halide is preferably a compound containing at least one atom selected from Zn, Cd, Ga, Ge, As, Se, In, Sn, Sb, Te, Tl, Pb, Bi, or Po.

The inorganic ligand preferably includes an atom contained in the quantum dot. For example, in a case where the quantum dot has InAs as a parent crystal, the inorganic ligand preferably contains at least one atom selected from In or As, and more preferably contains an In atom.

Specific examples of the inorganic ligand include zinc iodide, zinc bromide, zinc chloride, indium iodide, indium bromide, indium chloride, cadmium iodide, lead chloride, lead bromide, lead iodide, cadmium bromide, cadmium chloride, gallium iodide, gallium bromide, gallium chloride, potassium sulfide, and sodium sulfide.

The organic ligand may be a monodentate organic ligand having one coordination moiety or may be a multidentate organic ligand having two or more coordination moieties. Examples of the coordination moiety included in the organic ligand include a thiol group, an amino group, a hydroxy group, a carboxy group, a sulfo group, a phospho group, and a phosphonic acid group.

Specific examples of the monodentate organic ligand include 2-naphthylamine, 4-methylthioaniline, 4-methylbenzenethiol, 3,5-dimethylbenzenethiol, 4-chlorobenzenethiol, 4-methoxybenzenethiol, and benzoic acid.

Examples of the multidentate ligand include a ligand represented by any of Formulae (A) to (C).

$$X^{A1}-L^{A1}-X^{A2}$$

(A)

$$X^{B1}-L^{B1}-X^{B3}-L^{B2}-X^{B2}$$

(B)

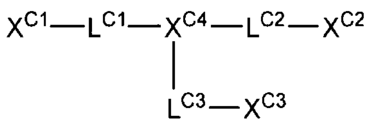

(C)

In Formula (A), $X^{A1}$ and $X^{A2}$ each independently represent a thiol group, an amino group, a hydroxy group, a carboxy group, a sulfo group, a phospho group, or a phosphonate group.
$L^{A1}$ represents a hydrocarbon group.

In Formula (B), $X^{B1}$ and $X^{B2}$ each independently represent a thiol group, an amino group, a hydroxy group, a carboxy group, a sulfo group, a phospho group, or a phosphonic acid group,

$X^{B3}$ represents S, O, or NH, and
$L^{B1}$ and $L^{B2}$ each independently represent a hydrocarbon group.

In Formula (C), $X^{C1}$ to $X^{C3}$ each independently represent a thiol group, an amino group, a hydroxy group, a carboxy group, a sulfo group, a phospho group, or a phosphonic acid group,

$X^{C4}$ represents N, and
$L^{C1}$ to $L^{C3}$ each independently represent a hydrocarbon group.

The amino group represented by $X^{A1}$, $X^{A2}$, $X^{B1}$, $X^{B2}$, $X^{C1}$, $X^{C2}$, or $X^{C3}$ is not limited to $-NH_2$ and includes a substituted amino group and a cyclic amino group as well. Examples of the substituted amino group include a monoalkylamino group, a dialkylamino group, a monoarylamino group, a diarylamino group, and an alkylarylamino group. The amino group represented by these groups is preferably $-NH_2$, a monoalkylamino group, or a dialkylamino group, and more preferably $-NH_2$.

The hydrocarbon group represented by $L^{A1}$, $L^{B1}$, $L^{B2}$, $L^{C1}$, $L^{C2}$, or $L^{C3}$ is preferably an aliphatic hydrocarbon group or a group including an aromatic ring, and more preferably the aliphatic hydrocarbon group. The aliphatic hydrocarbon group may be a saturated aliphatic hydrocarbon group or may be an unsaturated aliphatic hydrocarbon group. The hydrocarbon group preferably has 1 to 20 carbon atoms. An upper limit of the number of carbon atoms is preferably 10 or less, more preferably 6 or less, and still more preferably 3 or less. Specific examples of the hydrocarbon group include an alkylene group, an alkenylene group, an alkynylene group, and an arylene group.

Examples of the alkylene group include a linear alkylene group, a branched alkylene group, and a cyclic alkylene group. The linear alkylene group or the branched alkylene group is preferable, and the linear alkylene group is more

preferable. Examples of the alkenylene group include a linear alkenylene group, a branched alkenylene group, and a cyclic alkenylene group. The linear alkenylene group or the branched alkenylene group is preferable, and the linear alkenylene group is more preferable. Examples of the alkynylene group include a linear alkynylene group and a branched alkynylene group, and the linear alkynylene group is preferable. The arylene group may be a monocyclic ring or may be a polycyclic ring. The monocyclic arylene group is preferable. Specific examples of the arylene group include a phenylene group and a naphthylene group, and the phenylene group is preferable. The alkylene group, the alkenylene group, the alkynylene group, and the arylene group may further have a substituent. The substituent is preferably a group having 1 or more and 10 or less atoms. Preferred specific examples of the group having 1 or more and 10 or less of atoms include an alkyl group having 1 to 3 carbon atoms [a methyl group, an ethyl group, a propyl group, and an isopropyl group], an alkenyl group having 2 or 3 carbon atoms [an ethenyl group and a propenyl group], an alkynyl group having 2 to 4 carbon atoms [an ethynyl group, a propynyl group, and the like], a cyclopropyl group, an alkoxy group having 1 or 2 carbon atoms [a methoxy group and an ethoxy group], an acyl group having 2 or 3 carbon atoms [an acetyl group and a propionyl group], an alkoxycarbonyl group having 2 or 3 carbon atoms [a methoxycarbonyl group and an ethoxycarbonyl group], an acyloxy group having 2 carbon atoms [an acetyloxy group], an acylamino group having 2 carbon atoms [an acetylamino group], a hydroxyalkyl group having 1 to 3 carbon atoms [a hydroxymethyl group, a hydroxyethyl group, and a hydroxypropyl group], an aldehyde group, a hydroxy group, a carboxy group, a sulfo group, a phospho group, a carbamoyl group, a cyano group, an isocyanate group, a thiol group, a nitro group, a nitroxy group, an isothiocyanate group, a cyanate group, a thiocyanate group, an acetoxy group, an acetamide group, a formyl group, a formyloxy group, a formamide group, a sulfamino group, a sulfino group, a sulfamoyl group, a phosphono group, an acetyl group, a halogen atom, and an alkali metal atom.

In Formula (A), $X^{A1}$ and $X^{A2}$ are separated by $L^{A1}$, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (B), $X^{B1}$ and $X^{B3}$ are separated by $L^{B1}$, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, $X^{B2}$ and $X^{B3}$ are separated by $L^{B2}$, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (C), $X^{C1}$ and $X^{C4}$ are separated by $L^{C1}$, preferably by 1 to 10 atoms, more preferably by 1 to 6 atoms, still more preferably by 1 to 4 atoms, even still more preferably by 1 to 3 atoms, and particularly preferably by 1 or 2 atoms. Furthermore, $X^{C2}$ and $X^{C4}$ are separated by $L^{C2}$, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, $X^{C3}$ and $X^{C4}$ are separated by $L^{C3}$, preferably by 1 to 10 atoms, more preferably by 1 to 6 atoms, still more preferably by 1 to 4 atoms, even still more preferably by 1 to 3 atoms, and particularly preferably by 1 or 2 atoms.

Furthermore, the description that $X^{A1}$ and $X^{A2}$ are separated by $L^{A1}$ by 1 to 10 atoms means that the number of atoms constituting a molecular chain having the shortest distance, linking $X^{A1}$ and $X^{A2}$, is 1 to 10. For example, in a case of Formula (A1), $X^{A1}$ and $X^{A2}$ are separated by 2 atoms, and in cases of Formulae (A2) and (A3), $X^{A1}$ and $X^{A2}$ are separated by 3 atoms. The numbers added to the following structural formulae represent the arrangement order of atoms constituting a molecular chain having the shortest distance, linking $X^{A1}$ and $X^{A2}$.

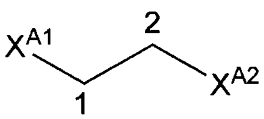

(A1)

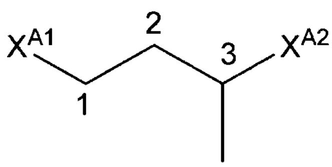

(A2)

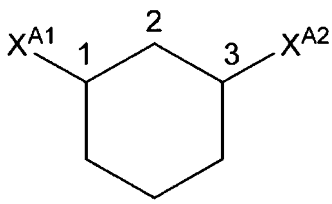

(A3)

To explain with a specific compound, 3-mercaptopropionic acid is a compound (a compound having the following structure) having a structure in which a moiety corresponding to $X^{A1}$ is a carboxy group, a moiety corresponding to $X^{A2}$ is a thiol group, and a moiety corresponding to $L^{A1}$ is an ethylene group. In 3-mercaptopropionic acid, $X^{A1}$ (carboxy group) and $X^{A2}$ (thiol group) are separated by $L^{A1}$ (ethylene group) by 2 atoms.

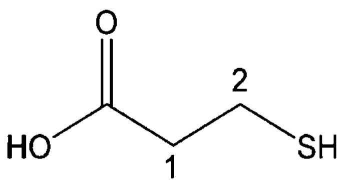

The same applies to the meanings that $X^{B1}$ and $X^{B3}$ are separated by $L^{B1}$ by 1 to 10 atoms, $X^{B2}$ and $X^{B3}$ are separated by $L^{B2}$ by 1 to 10 atoms, $X^{C1}$ and $X^{C4}$ are separated by $L^{C1}$ by 1 to 10 atoms, $X^{C2}$ and $X^{C4}$ are separated by $L^{C2}$ by 1 to 10 atoms, and $X^{C3}$ and $X^{C4}$ are separated by $L^{C3}$ by 1 to 10 atoms.

In Formula (A), the total number of carbon atoms in $X^{A1}$, $X^{A2}$, and $L^{A1}$ is preferably 7 or less.

In Formula (B), the total number of carbon atoms in $X^{B1}$, $X^{B2}$, $L^{B1}$, and $L^{B2}$ is preferably 7 or less.

In Formula (C), the total number of carbon atoms in $X^{C1}$, $X^{C2}$, $X^{C3}$, $L^{C1}$, $L^{C2}$, and $L^{C3}$ is preferably 7 or less.

Specific examples of the multidentate ligand include ethanedithiol, 3-mercaptopropionic acid, thiosalicylic acid, thioglycolic acid, 2-aminoethanol, 2-aminoethanethiol, 2-mercaptoethanol, glycolic acid, ethylene glycol ethylenediamine, aminosulfonic acid, glycine, aminomethylphosphoric acid, guanidine, diethylenetriamine, tris(2-aminoethyl)amine, 4-mercaptobutanoic acid, 3-aminopropanol, 3-mercaptopropanol, N-(3-aminopropyl)-1,3-propanediamine, 3-(bis(3-aminopropyl)amino)propan-1-ol,1-thioglycerol, dimercaprol, 1-mercapto-2-butanol, 1-mercapto-2-pentanol, 3-mercapto-1-propanol, 2,3-dimercapto-1-propanol, diethanolamine, 2-(2-aminoethyl)aminoethanol, dimethylenetriamine, 1,1-oxybismethylamine, 1,1-thiobismethylamine, 2-[(2-aminoethyl)amino]ethanethiol, bis(2-mercaptoethyl)amine, 2-aminoethane-1-thiol, 1-amino-2-butanol, 1-amino-2-pentanol, L-cysteine, D-cysteine, 3-amino-1-propanol, L-homoserine, D-homoserine, aminohydroxyacetic acid, L-lactic acid, D-lactic acid, L-malic acid, D-malic acid, glyceric acid, 2-hydroxybutyric acid, L-tartaric acid, D- tartaric acid, tartronic acid, 1,2-benzenedithiol, 1,3-benzenedithiol, 1,4-benzenedithiol, 2-mercaptobenzoic acid, 3-mercaptobenzoic acid, 4-mercaptobenzoic acid, 3-mercapto-2,2-bismercaptomethyl-1-propanol, trimethylolpropane tris(thioglycolate), pentaerythritol tetrakis(mercaptoacetate), dipentaerythritol hexakis(3-mercaptopropionate), dithioerythritol, and derivatives thereof.

The organic ligand is preferably a compound having 7 or less carbon atoms.

It is preferable that the ligand contained in the dispersion liquid includes at least one selected from an inorganic ligand or a compound having 7 or less carbon atoms. By using such a ligand, in the quantum dot film obtained using the dispersion liquid, the distance between the quantum dots in the film can be made closer, and a photodetector having more excellent external quantum efficiency and the like can be manufactured. In a case where such a ligand is used, soft aggregates of the quantum dots are likely to be formed in the quantum dot dispersion liquid, and the dispersibility tends to be reduced. However, in the embodiment of the present invention, by using at least one selected from a compound represented by Formula (1) or a polycyclic ketone compound as the solvent, a dispersion liquid can be obtained which can manufacture a quantum dot film having favorable dispersibility and suppressed thickness unevenness even in a case where such a ligand is used.

The content of the ligand in the dispersion liquid is preferably 1% to 15% by mass with respect to the total mass of the dispersion liquid. The lower limit thereof is preferably 2% by mass or more and more preferably 2.5% by mass or more. The lower limit thereof is preferably 10% by mass or less and more preferably 7% by mass or less.

In addition, the content of the ligand in the dispersion liquid is preferably 10 to 150 mg/mL. The lower limit thereof is preferably 20 mg/mL or more and more preferably 25 mg/mL or more. The upper limit thereof is preferably 100 mg/mL or less and more preferably 70 mg/mL or less.

In addition, the content of the ligand is preferably 10 to 100 parts by mass with respect to 100 parts by mass of the quantum dots. The lower limit thereof is preferably 20 parts by mass or more and more preferably 30 parts by mass or more. The upper limit thereof is preferably 80 parts by mass or less and more preferably 70 parts by mass or less.

(Solvent)

The dispersion liquid according to the embodiment of the present invention contains a solvent. As the solvent, at least one selected from a compound represented by Formula (1) or a polycyclic ketone compound is used. Hereinafter, the compound represented by Formula (1) and the polycyclic ketone compound used as the solvent are also collectively referred to as a specific solvent.

- Compound Represented by Formula (1) -

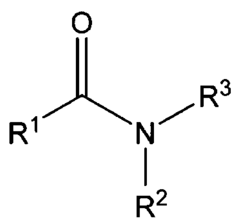

(1)

In Formula (1), $R^1$ represents a hydrogen atom or a substituent having 1 to 10 carbon atoms,

$R^2$ and $R^3$ each independently represent a hydrogen atom or a substituent having 1 to 10 carbon atoms, and two or more of $R^1$, $R^2$, and $R^3$ may be bonded to each other to form a ring structure,
where, in a case where $R^1$ is a hydrogen atom, at least one of $R^2$ or $R^3$ is a substituent having 2 or more carbon atoms.

$R^1$ in Formula (1) represents a hydrogen atom or a substituent having 1 to 10 carbon atoms, and preferably represents a substituent having 1 to 10 carbon atoms.
Examples of the substituent having 1 to 10 carbon atoms, represented by $R^1$, include an alkyl group having 1 to 10 carbon atoms, an alkylamino group having 1 to 10 carbon atoms, a substituent having 2 to 10 carbon atoms and including an ether bond, and a substituent having 2 to 10 carbon atoms and including a ketone group, and a substituent having 2 to 10 carbon atoms and including an ether bond is preferable. The substituent having 2 to 10 carbon atoms and including an ether bond is preferably a group represented by Formula (R-1).

$$-R^{11}-R^{12} \cdots \quad (R\text{-}1)$$

In Formula (R-1), $R^{11}$ represents an alkylene group, $R^{12}$ represents an alkoxy group, and the total number of carbon atoms in $R^{11}$ and $R^{12}$ is 2 to 10.
The number of carbon atoms in the alkylene group represented by $R^{11}$ is preferably 1 to 5 and more preferably 1 to 3. The alkylene group is preferably linear or branched, and more preferably linear.
The alkoxy group represented by $R^{12}$ preferably has 1 to 7 carbon atoms, more preferably has 1 to 5 carbon atoms, and still more preferably has 2 to 5 carbon atoms. The alkoxy group is preferably linear or branched, and more preferably linear.
$R^2$ and $R^3$ in Formula (1) each independently represent a hydrogen atom or a substituent having 1 to 10 carbon atoms, and preferably represent a substituent having 1 to 10 carbon atoms.
The substituent having 1 to 10 carbon atoms, represented by $R^2$ and $R^3$, is preferably an alkyl group having 1 to 10 carbon atoms, more preferably an alkyl group having 1 to 7 carbon atoms, and still more preferably an alkyl group having 1 to 5 carbon atoms. It is still more preferably an alkyl group having 1 to 3 carbon atoms. The alkyl group is preferably linear or branched, and more preferably linear. The substituent having 1 to 10 carbon atoms, represented by $R^2$ and $R^3$, is preferably a methyl group.
In Formula (1), two or more of $R^1$, $R^2$, and $R^3$ may be bonded to each other to form a ring structure. In a case of forming a ring structure, the ring structure to be formed is preferably a 5-membered ring or a 6-membered ring.
In a case where two or more of $R^1$, $R^2$, and $R^3$ are bonded to each other to form a ring structure, it is preferable that $R^1$ and $R^2$ are bonded to each other to form a ring structure. In a case where $R^1$ and $R^2$ are bonded to each other to form a ring structure, the compound represented by Formula (1) is preferably a compound represented by Formula (1a).

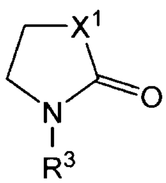

(1a)

In Formula (1a), $R^3$ represents a hydrogen atom or a substituent having 1 to 10 carbon atoms, $X^1$ represents $CR^{11}R^{12}$ or $NR^{13}$, and $R^{11}$ to $R^{13}$ each independently represent a hydrogen atom or an alkyl group having 1 to 5 carbon atoms.
A molecular weight of the compound represented by Formula (1) is preferably 75 to 250. The upper limit is preferably 200 or less and more preferably 175 or less. The lower limit is preferably 85 or more and more preferably 130 or more.
Specific examples of the compound represented by Formula (1) include 3-methoxy-N,N-dimethylpropanamide, 3-butoxy-N,N-dimethylpropanamide, 1-butylpyrrolidin-2-one, 1-methyl-2-pyrrolidone, 1,3-dimethyl-2-imidazolidinone, N,N-dimethylpropanamide, dimethylacetamide, 1,1,3,3-tetraethylurea, N,N-dimethylacetoacetamide, and N,N,N',N'-tetramethylmalonamide.

- Polycyclic Ketone Compound -

The polycyclic ketone compound is preferably a bicyclic to tetracyclic ketone compound, and more preferably a bicyclic or tricyclic ketone compound.

The polycyclic ketone compound is preferably a cyclic ketone compound having a crosslinked ring. The crosslinked ring refers to a ring in which two or more rings are linked to each other by a crosslinking group (not including a single bond) at two or more atoms that are not adjacent to each other in the rings. Examples of the crosslinking group include $-CH_2-$ and -O-, and -O- is preferable.

The polycyclic ketone compound is preferably a compound including a 5- to 7-membered ring structure including an oxygen atom as an atom constituting a ring, and more preferably a cyclic ketone compound having a crosslinked ring including a 5- to 7-membered ring structure having an oxygen atom as an atom constituting a ring.

A molecular weight of the polycyclic ketone compound is preferably 96 to 200. The upper limit is preferably 150 or less and more preferably 140 or less. The lower limit is preferably 100 or more and more preferably 120 or more.

Specific examples of the polycyclic ketone compound include dihydrolevoglucosenone.

A boiling point of the specific solvent is preferably 120°C to 350°C. The lower limit thereof is preferably 130°C or higher and more preferably 155°C or higher. The upper limit thereof is preferably 300°C or lower and more preferably 255°C or lower.

From the reason that the effect of the embodiment of the present invention is more remarkably exhibited, the specific solvent is preferably at least one selected from 3-methoxy-N,N-dimethylpropanamide, 3-butoxy-N,N-dimethylpropanamide, dihydrolevoglucosenone, or 1-butylpyrrolidin-2-one, and more preferably at least one selected from 3-methoxy-N,N-dimethylpropanamide, 3-butoxy-N,N-dimethylpropanamide, or 1-butylpyrrolidin-2-one.

The solvent used in the dispersion liquid may include a solvent (other solvent) other than the specific solvent described above. The other solvent is preferably an organic solvent. The organic solvent used as the other solvent may be a protic solvent or may be an aprotic solvent; however, it is preferably an aprotic solvent and more preferably an aprotic polar solvent.

Specific examples of the other solvent include an alkane [n-hexane, n-octane, and the like], benzene, toluene, propylene carbonate, and ethylene glycol.

The content of the solvent in the dispersion liquid is preferably 50% to 99% by mass, more preferably 70% to 99% by mass, and still more preferably 85% to 98% by mass, with respect to the total mass of the dispersion liquid.

A content of the specific solvent described above in the dispersion liquid (that is, a total content of the compound represented by Formula (1) and the polycyclic ketone compound) is preferably 50% to 99% by mass, more preferably 70% to 99% by mass, and still more preferably 85% to 98% by mass with respect to the total mass of the dispersion liquid.

A content of the specific solvent in the solvent contained in the dispersion liquid (that is, a total content of the compound represented by Formula (1) and the polycyclic ketone compound) is preferably 80% to 100% by mass, more preferably 90% to 100% by mass, and still more preferably 95% to 100% by mass. The solvent contained in the dispersion liquid is preferably substantially only the specific solvent described above. In the present specification, the case where the solvent is substantially only the specific solvent means that the content of the specific solvent in the solvent is 99% by mass or more, preferably 99.9% by mass or more, and more preferably only the specific solvent.

The solvent contained in the dispersion liquid may be only one kind or may be a mixed solvent in which two or more kinds are mixed. In a case where the dispersion liquid contains two or more kinds of solvents, it is preferable that the total amount thereof is in the above-described ranges.

From the viewpoint of environmental regulation, the use of a fluorine-containing compound may be regulated. In a case of reducing the content of the fluorine-containing compound in the dispersion liquid, the content of the fluorine-containing compound in the dispersion liquid is preferably 5% by mass or less, more preferably 1% by mass or less, and still more preferably 0.1% by mass or less. In addition, the dispersion liquid may not substantially contain a fluorine-containing compound.

<Method For Manufacturing Quantum Dot Film>

The method for manufacturing a quantum dot film according to the embodiment of the present invention includes a step of applying the above-described dispersion liquid according to the embodiment of the present invention onto a support to form a composition layer, and a step of drying the composition layer.

The shape, structure, size, and the like of the support onto which the dispersion liquid is applied are not particularly limited and can be appropriately selected according to the intended purpose. The structure of the support may be a monolayer structure or may be a laminated structure. As the support, for example, a support composed of an inorganic material such as silicon, glass, or yttria-stabilized zirconia (YSZ), a resin, a resin composite material, or the like can be used. In addition, an electrode, an insulating film, or the like may be formed on the support. In this case, the dispersion liquid is also applied onto the electrode or the insulating film on the support.

A method for applying the dispersion liquid onto a support is not particularly limited. Examples thereof include coating methods such as a spin coating method, a dipping method, an ink jet method, a dispenser method, a screen printing method, a relief printing method, an intaglio printing method, and a spray coating method.

After forming the composition layer, drying is carried out. By carrying out drying, the solvent remaining in the

composition layer can be removed.

The drying temperature is preferably 50°C to 300°C. The upper limit of the drying temperature is preferably 200°C or lower and more preferably 150°C or lower. The lower limit of the drying temperature is preferably 60°C or higher and more preferably 100°C or higher. In a case where the drying temperature is within the above-described range, it is possible to manufacture a quantum dot film with few surface defects and having a small interval between the quantum dots.

The drying time is preferably 1 to 30 minutes. The upper limit of the drying time is preferably 20 minutes or less and more preferably 10 minutes or less. The lower limit of the drying time is preferably 2 minutes or more and more preferably 5 minutes or more. In a case where the drying time is within the above-described range, it is possible to manufacture a quantum dot film with few surface defects and having a small interval between the quantum dots.

In the method for manufacturing a quantum dot film according to the embodiment of the present invention, a step of forming a composition layer and a step of drying the composition layer may be alternately repeated a plurality of times.

In the method for manufacturing a quantum dot film according to the embodiment of the present invention, a step of applying a ligand solution may be performed after the step of drying the composition layer. In a case where this step is performed, the ligand coordinated to the quantum dots can be exchanged with a ligand contained in the ligand solution, or a ligand contained in the ligand solution can be coordinated to the quantum dot to suppress the generation of surface defects of the quantum dots.

Examples of the ligand contained in the ligand solution include the ligands described as those that are used in the dispersion liquid according to the embodiment of the present invention. The ligand contained in the ligand solution may be the same as or different from the ligand contained in the dispersion liquid. The ligand solution may contain only one kind or two or more kinds of the ligands. In addition, in the step of applying the ligand solution, two or more kinds of the ligand solutions may be used.

The solvent contained in the ligand solution is preferably selected appropriately according to the kind of the ligand contained in the ligand solution, and it is preferably a solvent that easily dissolves the ligand. In addition, the solvent contained in the ligand solution is preferably an organic solvent having a high permittivity. Specific examples thereof include ethanol, acetone, methanol, acetonitrile, dimethylformamide, dimethyl sulfoxide, butanol, and propanol. In addition, the solvent can also use the solvent described as the solvent used in the dispersion liquid according to the embodiment of the present invention. In addition, the solvent contained in the ligand solution is preferably a solvent that does not easily remain in the quantum dot film to be formed. It is preferably an alcohol, ketone, or nitrile which has a low boiling point, and more preferably methanol, ethanol, acetone, or acetonitrile from the viewpoint of easy drying and easy removal by washing.

A method for applying the ligand solution is the same as the method for applying the dispersion liquid onto the support, and the same applies to the preferred aspect thereof.

In a case where the step of applying the ligand solution is carried out, a step (rinsing step) of bringing the film after the application of the ligand solution into contact with a rinsing liquid to rinse the film may be carried out. In a case where the rinsing step is carried out, it is possible to remove the excessive ligand contained in the film and the ligand eliminated from the quantum dots. In addition, it is possible to remove the remaining solvent and other impurities. The rinsing liquid is preferably an aprotic solvent for the reason that it is easier to effectively remove excess ligands contained in the film and ligands eliminated from the quantum dots, and it is easy to keep the film surface shape uniform by rearranging the surfaces of the quantum dots. Specific examples of the aprotic solvent include acetonitrile, acetone, methyl ethyl ketone, methyl isobutyl ketone, cyclopentanone, diethyl ether, tetrahydrofuran, cyclopentyl methyl ether, dioxane, ethyl acetate, butyl acetate, propylene glycol monomethyl ether acetate, hexane, octane, cyclohexane, benzene, toluene, chloroform, carbon tetrachloride, and dimethylformamide, where acetonitrile and tetrahydrofuran is preferable, and acetonitrile is more preferable.

In addition, the rinsing step may be performed a plurality of times by using two or more kinds of rinsing liquids that differ in polarity (relative permittivity). For example, it is preferable that first, a rinsing liquid having a high relative permittivity (also referred to as a first rinsing liquid) is used to perform rinsing, and then a rinsing liquid having a relative permittivity lower than that of the first rinsing liquid (also referred to as a second rinsing liquid) is used to perform rinsing. The relative permittivity of the first rinsing liquid is preferably 15 to 50, more preferably 20 to 45, and still more preferably 25 to 40. The relative permittivity of the second rinsing liquid is preferably 1 to 15, more preferably 1 to 10, and still more preferably 1 to 5.

A quantum dot film can be manufactured through such steps. The quantum dot film obtained by the method for manufacturing a quantum dot film according to the embodiment of the present invention can be used for a photodetector or an image sensor. More specifically, it can be used for a photoelectric conversion layer of a photodetector or an image sensor.

<Photodetector and Method for Manufacturing the Same>

The dispersion liquid according to the embodiment of the present invention can be used in a photodetector. More preferably, it is used for forming a photoelectric conversion layer of a photodetector. In addition, the method for

manufacturing a photodetector according to the embodiment of the present invention includes the above-described method for manufacturing a quantum dot film according to the embodiment of the present invention. Specifically, it is preferable that the photoelectric conversion layer of the photodetector is formed using the above-described method for manufacturing a quantum dot film according to the embodiment of the present invention.

Examples of the type of photodetector include a photoconductor-type photodetector and a photodiode-type photodetector. Among the above, a photodiode-type photodetector is preferable for the reason that a high signal-to-noise ratio (SN ratio) is easily obtained.

Since the quantum dot film obtained by using the dispersion liquid according to the embodiment of the present invention has excellent sensitivity to the light having a wavelength in the infrared region, a photodetector in which this quantum dot film is used for a photoelectric conversion layer is preferably used as a photodetector that detects light having a wavelength in the infrared region. That is, the photodetector is preferably used as an infrared photodetector.

The light having a wavelength in the infrared region is preferably light having a wavelength of more than 700 nm, more preferably light having a wavelength of 800 nm or more, and still more preferably light having a wavelength of 900 nm or more. In addition, the light having a wavelength in the infrared region is preferably light having a wavelength of 2,000 nm or less and more preferably light having a wavelength of 1,600 nm or less.

The photodetector may be a photodetector that simultaneously detects light having a wavelength in the infrared region and light having a wavelength in the visible region (preferably light having a wavelength range of 400 to 700 nm).

FIG. 1 is a view illustrating an embodiment of a photodetector. FIG. 1 is a view illustrating an embodiment of a photodiode-type photodetector. Furthermore, an arrow in the drawing represents the incident ray on the photodetector. A photodetector 1 illustrated in FIG. 1 includes a second electrode 12, a first electrode 11 provided to face the second electrode 12, a photoelectric conversion layer 13 provided between the second electrode 12 and the first electrode 11, an electron transport layer 21 provided between the first electrode 11 and the photoelectric conversion layer 13, and a hole transport layer 22 provided between the second electrode 12 and the photoelectric conversion layer 13. The photodetector 1 illustrated in FIG. 1 is used with light incident from above the first electrode 11. Although not illustrated in the drawing, a transparent substrate may be disposed on the surface of the first electrode 11 on the light incident side. Examples of the kind of transparent substrate include a glass substrate, a resin substrate, and a ceramic substrate.

(First Electrode)

The first electrode 11 is preferably a transparent electrode formed of a conductive material that is substantially transparent with respect to the wavelength of target light to be detected by the photodetector. Furthermore, in the present specification, the description of "substantially transparent" means that the transmittance of light is 50% or more, preferably 60% or more, and particularly preferably 80% or more. Examples of the material of the first electrode 11 include a conductive metal oxide. Specific examples thereof include tin oxide, zinc oxide, indium oxide, indium tungsten oxide, indium zinc oxide (IZO), indium tin oxide (ITO), and a fluorine-doped tin oxide (FTO).

The film thickness of the first electrode 11 is not particularly limited, and it is preferably 0.01 to 100 μm, more preferably 0.01 to 10 μm, and still more preferably 0.01 to 1 μm. The film thickness of each layer can be measured by observing the cross section of the photodetector 1 using a scanning electron microscope (SEM) or the like.

(Electron Transport Layer)

The electron transport layer 21 is a layer having a function of transporting electrons generated in the photoelectric conversion layer 13 to the electrode. The electron transport layer is also called a hole block layer. The electron transport layer is formed of an electron transport material capable of exhibiting this function.

Examples of the electron transport material include fullerene compounds such as [6,6]-phenyl-C61-butyric acid methyl ester ($PC_{61}BM$), perylene compounds such as perylenetetracarboxylic diimide, tetracyanoquinodimethane, titanium oxide, tin oxide, zinc oxide, indium oxide, indium tungsten oxide, indium zinc oxide, indium tin oxide, and fluorine-doped tin oxide. The electron transport material may be a particle.

In addition, it is also preferable that the electron transport layer is composed of a layer containing zinc oxide doped with a metal atom other than Zn. Hereinafter, the zinc oxide doped with a metal atom other than Zn is also referred to as the doped zinc oxide.

The metal atom other than Zn in the doped zinc oxide is preferably a monovalent to trivalent metal atom, more preferably a metal atom including at least one selected from Li, Mg, Al, or Ga, still more preferably Li, Mg, Al, or Ga, and particularly preferably Li or Mg.

In the doped zinc oxide, a proportion of the metal atoms other than Zn to a total of Zn and the metal atoms other than Zn is preferably 1% by atom or more, more preferably 2% by atom or more, and still more preferably 4% by atom or more. From the viewpoint of suppressing an increase in crystal defects, an upper limit of the proportion is preferably 20% by atom or less, more preferably 15% by atom or less, and still more preferably 12% by atom or less. Furthermore, a proportion

of the metal atoms other than Zn in the doped zinc oxide can be measured according to a high-frequency inductively coupled plasma (ICP) method.

From the viewpoint of reducing the organic residual component and increasing the area for contact with the photoelectric conversion layer, the doped zinc oxide is preferably a particle (doped zinc oxide particle). In addition, an average particle diameter of the doped zinc oxide particles is preferably 2 to 30 nm. A lower limit value of the average particle diameter of the doped zinc oxide particles is preferably 3 nm or more, and more preferably 5 nm or more. In addition, an upper limit value of the average particle diameter of the doped zinc oxide particles is preferably 20 nm or less, and more preferably 15 nm or less. In a case where the average particle diameter of the doped zinc oxide particles is within the above-described range, it is easy to obtain a film that has a large area for contact with the photoelectric conversion layer and has a high flatness. Furthermore, in the present specification, the value of the average particle diameter of the doped zinc oxide particles is an average value of the particle diameters of ten quantum dots which are randomly selected. A transmission electron microscope may be used to measure the particle diameters of the doped zinc oxide particles.

The electron transport layer may be a single-layer film or a laminated film having two or more layers. A thickness of the electron transport layer is preferably 10 to 1,000 nm. An upper limit thereof is preferably 800 nm or less. A lower limit thereof is preferably 20 nm or more, and more preferably 50 nm or more. In addition, the thickness of the electron transport layer is preferably 0.05 to 10 times, more preferably 0.1 to 5 times, and still more preferably 0.2 to 2 times the thickness of the photoelectric conversion layer 13.

The electron transport layer may be subjected to ultraviolet ozone treatment. In particular, in a case of a layer consisting of nanoparticles as the electron transport layer, it is desirable to carry out ultraviolet ozone treatment. In a case where the ultraviolet ozone treatment is carried out, it is possible to improve the wettability of the quantum dot dispersion liquid on the electron transport layer and decompose or remove the residual organic substances in the electron transport layer, which makes it possible to obtain high element performance. The wavelength of the ultraviolet rays for irradiation can be selected in a wavelength range of 100 to 400 nm. In particular, for the reason that the above-described effect is easily obtained and excessive damage to a film can be avoided, it is preferable that the peak intensity is present in a wavelength range of 200 to 300 nm, and it is more preferable that the peak intensity is present in a wavelength range of 240 to 270 nm. The irradiation intensity of the ultraviolet rays is not particularly limited; however, it is preferably 1 to 100 $mW/cm^2$ and more preferably 10 to 50 $mW/cm^2$ for the reason that the above-described effect is easily obtained and excessive damage to a film can be avoided. The treatment time is not particularly limited; however, it is preferably 1 to 60 minutes, more preferably 1 to 20 minutes, and still more preferably 3 to 15 minutes, for the same reason as described above.

(Photoelectric Conversion Layer)

The photoelectric conversion layer 13 is composed of a quantum dot film formed by using the above-described dispersion liquid according to the embodiment of the present invention. The photoelectric conversion layer 13 can be manufactured by the above-described method for manufacturing a quantum dot film according to the embodiment of the present invention.

The thickness of the photoelectric conversion layer 13 is preferably 10 to 1,000 nm. The lower limit of the thickness is preferably 20 nm or more and more preferably 30 nm or more. The upper limit of the thickness is preferably 600 nm or less, more preferably 550 nm or less, still more preferably 500 nm or less, and particularly preferably 450 nm or less. The refractive index of the photoelectric conversion layer 13 with respect to light having a target wavelength to be detected by the photodetector can be set to 1.5 to 5.0.

(Hole Transport Layer)

The hole transport layer 22 is a layer having a function of transporting holes generated in the photoelectric conversion layer 13 to the electrode. The hole transport layer is also called an electron block layer.

The hole transport layer 22 is formed of a hole transport material capable of exhibiting this function. Examples of the hole transport material include PEDOT:PSS (poly(3,4-ethylenedioxythiophene):poly(4-styrenesulfonic acid)), PTB7 (poly{4,8-bis[(2-ethylhexyl)oxy]benzo[1,2-b:4,5-b']dithiophen-2,6-diyl-lt-alt-3-fluoro-2-[(2-et hylhexyl)carbonyl]thieno [3,4-b]thiophen-4,6-diyl}), PTB7-Th (poly([2,6'-4,8-di(5-ethylhexylthienyl)benzo[1,2-b:3,3-b]dithiophene]{3-fluoro-2-[(2-ethylhex yl 1)carbonyl]thieno[3,4-b]thiophendiyl})), PC71BM ([6,6]-phenyl-C71-methyl butyrate), and $MoO_3$. Furthermore, the organic hole transport material disclosed in paragraph Nos. 0209 to 0212 of JP2001-291534A can also be used. In addition, quantum dots can also be used in the hole transport material. Examples of the quantum dot material constituting the quantum dot include nanoparticles (a particle having a size of 0.5 nm or more and less than 100 nm) of general semiconductor crystals [a) a Group IV semiconductor, b) a compound semiconductor of Group IV-IV, Group III-V, or Group II-VI, or c) a compound semiconductor consisting of a combination of three or more of a Group II element, a Group III element, a Group IV element, a Group V element, and a Group VI element]. Specific examples thereof include semiconductor materials having a relatively narrow band gap, such as PbS, PbSe, PbSeS, InN, Ge, InAs, InGaAs, CuInS,

CuInSe, CuInGaSe, InSb, HgTe, HgCdTe, $Ag_2S$, $Ag_2Se$, $Ag_2Te$, SnS, SnSe, SnTe, Si, and InP. A ligand may be coordinated to surfaces of the quantum dots.

The thickness of the hole transport layer 22 is preferably 5 to 100 nm. A lower limit thereof is preferably 10 nm or more. An upper limit thereof is preferably 50 nm or less, and more preferably 30 nm or less.

(Second Electrode)

The second electrode 12 is preferably composed of a metal material including at least one metal atom selected from Ag, Au, Pt, Ir, Pd, Cu, Pb, Sn, Zn, Ti, W, Mo, Ta, Ge, Ni, Al, Cr, or In. Since the second electrode 12 is composed of such a metal material, it is possible for the photodetector to have a high external quantum efficiency and a low dark current. In addition, the above-described conductive metal oxide, a carbon material, a conductive polymer, and the like can also be used for the second electrode 12. The carbon material may be any material having conductivity, and examples thereof include fullerene, a carbon nanotube, graphite, and graphene.

The work function of the second electrode 12 is preferably 4.6 eV or more, more preferably 4.8 to 5.7 eV, and still more preferably 4.9 to 5.3 eV, for the reason that the electron blocking property due to the hole transport layer is increased and the holes generated in the element are easily collected.

The film thickness of the second electrode 12 is not particularly limited, and it is preferably 0.01 to 100 μm, more preferably 0.01 to 10 μm, and particularly preferably 0.01 to 1 μm.

(Blocking Layer)

Although not illustrated in the drawing, the photodetector may have a blocking layer between the first electrode 11 and the electron transport layer 21. The blocking layer is a layer having a function of preventing a reverse current. The blocking layer is also called a short circuit prevention layer. Examples of the material that forms the blocking layer include silicon oxide, magnesium oxide, aluminum oxide, calcium carbonate, cesium carbonate, polyvinyl alcohol, polyurethane, titanium oxide, tin oxide, zinc oxide, niobium oxide, and tungsten oxide. The blocking layer may be a single-layer film or a laminated film having two or more layers.

In the photodetector, a wavelength λ of the target light to be detected by the photodetector and an optical path length $L^{\lambda}$ of the light having the wavelength λ from the surface of the second electrode 12 on the side of the photoelectric conversion layer 13 to the surface of the photoelectric conversion layer 13 on the side of the first electrode 11 preferably satisfy the relationship of Expression (1-1), and more preferably satisfy the relationship of Expression (1-2). In a case where the wavelength λ and the optical path length $L^{\lambda}$ satisfy such a relationship, in the photoelectric conversion layer 13, it is possible to arrange phases of the light (the incidence ray) incident from the side of the first electrode 11 and phases of the light (the reflected light) reflected on the surface of the second electrode 12, and as a result, the light is intensified by the optical interference effect, whereby it is possible to obtain a higher external quantum efficiency.

$$0.05 + m/2 \leq L^{\lambda}/\lambda \leq 0.35 + m/2 \quad \cdots(1\text{-}1)$$

$$0.10 + m/2 \leq L^{\lambda}/\lambda \leq 0.30 + m/2 \quad \cdots(1\text{-}2)$$

In the above expressions, λ is the wavelength of the target light to be detected by the photodetector,

$L^{\lambda}$ is the optical path length of the light having the wavelength λ from a surface of the second electrode 12 on a side of the photoelectric conversion layer 13 to a surface of the photoelectric conversion layer 13 on a side of the first electrode 11, and
m is an integer of 0 or more.

m is preferably an integer of 0 to 4, more preferably an integer of 0 to 3, and still more preferably an integer of 0 to 2. According to this aspect, the transport characteristics of charges such as the hole and the electron are good, and thus it is possible to increase the external quantum efficiency of the photodetector.

Here, the optical path length means the product obtained by multiplying the physical thickness of a substance through which light transmits by the refractive index. To make a description with the photoelectric conversion layer 13 as an example, in a case where the thickness of the photoelectric conversion layer is denoted by $d^1$ and the refractive index of the photoelectric conversion layer with respect to light having a wavelength $\lambda^1$ is denoted by $N^1$, the optical path length of the light having the wavelength $\lambda^1$ and transmitting through the photoelectric conversion layer 13 is $N^1 \times d^1$. In a case where the photoelectric conversion layer 13 or the hole transport layer 22 is composed of laminated films having two or more layers or in a case where an interlayer is present between the hole transport layer 22 and the second electrode 12, the

integrated value of the optical path length of each layer is the optical path length $L^{\lambda}$.

<Image Sensor and Method for Manufacturing the Same>

The dispersion liquid according to the embodiment of the present invention can be used in an image sensor. More preferably, it is used for forming a photoelectric conversion layer of an image sensor. In addition, the manufacturing method for an image sensor according to the embodiment of the present invention includes the above-described manufacturing method for a quantum dot film according to the embodiment of the present invention. Specifically, it is preferable that the photoelectric conversion layer of the image sensor is formed using the above-described method for manufacturing a quantum dot film according to the embodiment of the present invention.

Since the quantum dot film obtained by using the dispersion liquid according to the embodiment of the present invention has excellent sensitivity to light having a wavelength in the infrared region, an image sensor in which this quantum dot is used for a photoelectric conversion layer can be particularly preferably used as an infrared sensor. In addition, the image sensor can be preferably used as a sensor that senses light at a wavelength of 900 to 2,000 nm, and can be more preferably used as a sensor that senses light at a wavelength of 900 to 1,600 nm.

The configuration of the image sensor is not particularly limited as long as it comprises the photodetector and it is a configuration that functions as an image sensor. Examples of the photodetector include the above-described photodetector.

The image sensor may include an infrared transmitting filter layer. The infrared transmitting filter layer preferably has a low light transmittance in the wavelength band of the visible region, more preferably has an average light transmittance of 10% or less, still more preferably 7.5% or less, and particularly preferably 5% or less, in a wavelength range of 400 to 650 nm.

Examples of the infrared transmitting filter layer include those composed of a resin film containing a coloring material. Examples of the coloring material include a chromatic coloring material such as a red coloring material, a green coloring material, a blue coloring material, a yellow coloring material, a purple coloring material, and an orange coloring material, and a black coloring material. It is preferable that the coloring material contained in the infrared transmitting filter layer forms a black color with a combination of two or more kinds of chromatic coloring materials or is a coloring material containing a black coloring material. Examples of the combination of the chromatic coloring material in a case of forming a black color by a combination of two or more kinds of chromatic coloring materials include the following aspects (C1) to (C7).

(C1) An aspect containing a red coloring material and a blue coloring material.
(C2) An aspect containing a red coloring material, a blue coloring material, and a yellow coloring material.
(C3) An aspect containing a red coloring material, a blue coloring material, a yellow coloring material, and a purple coloring material.
(C4) An aspect containing a red coloring material, a blue coloring material, a yellow coloring material, a purple coloring material, and a green coloring material.
(C5) An aspect containing a red coloring material, a blue coloring material, a yellow coloring material, and a green coloring material.
(C6) An aspect containing a red coloring material, a blue coloring material, and a green coloring material.
(C7) An aspect containing a yellow coloring material and a purple coloring material.

The chromatic coloring material may be a pigment or a dye. The chromatic coloring material may contain a pigment and a dye. The black coloring material is preferably an organic black coloring material. Examples of the organic black coloring material include a bisbenzofuranone compound, an azomethine compound, a perylene compound, and an azo compound.

The infrared transmitting filter layer may further contain an infrared absorber. In a case where the infrared absorber is contained in the infrared transmitting filter layer, the wavelength of the light to be transmitted can be shifted to the longer wave side. Examples of the infrared absorber include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride.

The spectral characteristics of the infrared transmitting filter layer can be appropriately selected according to the use application of the image sensor. Examples of the filter layer include those that satisfy any one of the following spectral characteristics of (1) to (5).

(1): A filter layer in which the maximum value of the light transmittance in the film thickness direction in a wavelength range of 400 to 750 nm is 20% or less (preferably 15% or less and more preferably 10% or less), and the minimum

value of the light transmittance in the film thickness direction in a wavelength range of 900 to 1,500 nm is 70% or more (preferably 75% or more and more preferably 80% or more).

(2): A filter layer in which the maximum value of the light transmittance in the film thickness direction in a wavelength range of 400 to 830 nm is 20% or less (preferably 15% or less and more preferably 10% or less), and the minimum value of the light transmittance in the film thickness direction in a wavelength range of 1,000 to 1,500 nm is 70% or more (preferably 75% or more and more preferably 80% or more).

(3): A filter layer in which the maximum value of the light transmittance in the film thickness direction in a wavelength range of 400 to 950 nm is 20% or less (preferably 15% or less and more preferably 10% or less), and the minimum value of the light transmittance in the film thickness direction in a wavelength range of 1,100 to 1,500 nm is 70% or more (preferably 75% or more and more preferably 80% or more).

(4): A filter layer in which the maximum value of the light transmittance in the film thickness direction in a wavelength range of 400 to 1,100 nm is 20% or less (preferably 15% or less and more preferably 10% or less), and the minimum value thereof in a wavelength range of 1,400 to 1,500 nm is 70% or more (preferably 75% or more and more preferably 80% or more).

(5): A filter layer in which the maximum value of the light transmittance in the film thickness direction in a wavelength range of 400 to 1,300 nm is 20% or less (preferably 15% or less and more preferably 10% or less), and the minimum value thereof in a wavelength range of 1,600 to 2,000 nm is 70% or more (preferably 75% or more and more preferably 80% or more).

Further, as the infrared transmitting filter, the films disclosed in JP2013-077009A, JP2014-130173A, JP2014-130338A, WO2015/166779A, WO2016/178346A, WO2016/190162A, WO2018/016232A, JP2016-177079A, JP2014-130332A, and WO2016/027798A can be used. As the infrared transmitting filter, two or more filters may be used in combination, or a dual bandpass filter that transmits through two or more specific wavelength regions with one filter may be used.

The image sensor may include an infrared shielding filter for the intended purpose of improving various performances such as noise reduction. Specific examples of the infrared shielding filter include the filters disclosed in WO2016/186050A, WO2016/035695A, JP6248945B, WO2019/021767A, JP2017-067963A, and JP6506529B.

The image sensor may include a dielectric multi-layer film. Examples of the dielectric multi-layer film include those in which a plurality of layers are laminated by alternately laminating a dielectric thin film having a high refractive index (a high refractive index material layer) and a dielectric thin film having a low refractive index (a low refractive index material layer). The number of lamination layers of the dielectric thin film in the dielectric multi-layer film is not particularly limited, but is preferably 2 to 100 layers, more preferably 4 to 60 layers, and still more preferably 6 to 40 layers. The material that is used for forming the high refractive index material layer is preferably a material having a refractive index of 1.7 to 2.5. Specific examples thereof include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$, TlCl, $Y_2O_3$, ZnSe, ZnS, and $ZrO_2$. The material that is used for forming the low refractive index material layer is preferably a material having a refractive index of 1.2 to 1.6. Specific examples thereof include $Al_2O_3$, $BiF_3$, $CaF_2$, $LaF_3$, $PbCl_2$, $PbF_2$, LiF, $MgF_2$, MgO, $NdF_3$, $SiO_2$, $Si_2O_3$, NaF, $ThO_2$, $ThF_4$, and $Na_3AlF_6$. The method for forming the dielectric multi-layer film is not particularly limited; however, examples thereof include ion plating, a vacuum vapor deposition method using an ion beam or the like, a physical vapor deposition method (PVD method) such as sputtering, and a chemical vapor deposition method (CVD method). The thickness of each of the high refractive index material layer and the low refractive index material layer is preferably 0.1 $\lambda$ to 0.5 $\lambda$ in a case where the wavelength of the light to be blocked is $\lambda$ (nm). Specific examples of the usable dielectric multi-layer film include the films disclosed in JP2014-130344A and JP2018-010296A.

In the dielectric multi-layer film, the transmission wavelength band is preferably present in the infrared region (preferably a wavelength range having a wavelength of more than 700 nm, more preferably a wavelength range having a wavelength of more than 800 nm, and still more preferably a wavelength range having a wavelength of more than 900 nm). The maximum transmittance in the transmission wavelength band is preferably 70% or more, more preferably 80% or more, and still more preferably 90% or more. In addition, the maximum transmittance in the shielding wavelength range is preferably 20% or less, more preferably 10% or less, and still more preferably 5% or less. In addition, the average transmittance in the transmission wavelength range is preferably 60% or more, more preferably 70% or more, and still more preferably 80% or more. In addition, in a case where the wavelength at which the maximum transmittance is exhibited is denoted by a central wavelength $\lambda_{t1}$, the wavelength range of the transmission wavelength range is preferably the central wavelength $\lambda_{t1} \pm 100$ nm, more preferably the central wavelength $\lambda_{t1} \pm 75$ nm, and still more preferably the central wavelength $\lambda_{t1} \pm 50$ nm.

The dielectric multi-layer film may have only one transmission wavelength range (preferably, a transmission wavelength range having a maximum transmittance of 90% or more) or may have a plurality of transmission wavelength ranges.

The image sensor may include a color separation filter layer. Examples of the color separation filter layer include a filter layer including colored pixels. Examples of the kind of colored pixel include a red pixel, a green pixel, a blue pixel, a

yellow pixel, a cyan pixel, and a magenta pixel. The color separation filter layer may include colored pixels having two or more colors or having only one color. It can be appropriately selected according to the use application and the intended purpose. For example, the filter disclosed in WO2019/039172A can be used.

In addition, in a case where the color separation layer includes colored pixels having two or more colors, the colored pixels of the respective colors may be adjacent to each other, or a partition wall may be provided between the respective colored pixels. The material of the partition wall is not particularly limited. Examples thereof include organic materials such as a siloxane resin and a fluororesin, and inorganic particles such as a silica particle. In addition, the partition wall may be composed of a metal such as tungsten and aluminum.

It is noted that in a case where the image sensor includes an infrared transmitting filter layer and a color separation layer, it is preferable that the color separation layer is provided on an optical path different from the infrared transmitting filter layer. In addition, it is also preferable that the infrared transmitting filter layer and the color separation layer are disposed two-dimensionally. It is noted that the description that the infrared transmitting filter layer and the color separation layer are disposed two-dimensionally means that at least parts of both are present on the same plane.

The image sensor may include an interlayer such as a planarizing layer, an underlying layer, or an intimate attachment layer, an anti-reflection film, and a lens. As the anti-reflection film, for example, a film produced from the composition disclosed in WO2019/017280A can be used. As the lens, for example, the structure disclosed in WO2018/092600A can be used.

## Examples

Hereinafter, the present invention will be described in detail with reference to Examples. Materials, amounts used, proportions, treatment details, treatment procedures, and the like shown in the following examples can be appropriately changed without departing from the gist of the present invention. Therefore, the scope of the present invention is not limited to the specific examples described below.

### [Production of dispersion liquid] (Examples 1 to 35 and Comparative Examples 1 to 3)

1 mL of an octane dispersion liquid of quantum dots (concentration of quantum dots: 50 mg/mL, concentration of oleic acid: 50 mg/mL) having a surface to which oleic acid was coordinated, the quantum dots being described in the table below, 0.5 g of a ligand described in the table below, and 5 mL of the solvent described in the table below were measured and put in a centrifugal separation tube, and the resultant mixture was vigorously stirred for 10 minutes. Next, 30 mL of octane was added thereto, followed by vigorous stirring for 1 minute. Then, the operation of removing the upper layer as the octane layer was repeated twice. Then, an excessive amount of toluene was added thereto, followed by centrifugal separation at 4,000 rpm for 5 minutes. The obtained precipitate was dried at 25°C under a pressure of 1.0 mmHg for 30 minutes, 0.5 mL of the solvent described in the table below was added thereto, and the resultant mixture was stirred for 1 hour to obtain a ligand-exchanged dispersion liquid (Examples 1 to 35 and Comparative examples 1 to 3). It is noted that all of the above-described operations were carried out under nitrogen.

[Table 1]

| | Quantum Dots | | Ligand | Solvent |
|---|---|---|---|---|
| | Type | Band Gap (eV) | | |
| Example 1 | PbS | 0.81 | $InBr_3$ | S-1 |
| Example 2 | PbS | 0.80 | $InBr_3$ | S-2 |
| Example 3 | PbS | 0.85 | $InBr_3$ | S-3 |
| Example 4 | PbS | 0.82 | $InBr_3$ | S-4 |
| Example 5 | PbS | 0.83 | $InBr_3$ | S-5 |
| Example 6 | PbS | 0.80 | 3-mercaptopropionic acid | S-1 |
| Example 7 | PbS | 0.81 | 3-mercaptopropionic acid | S-2 |
| Example 8 | PbS | 0.84 | 3-mercaptopropionic acid | S-3 |
| Example 9 | PbS | 0.81 | 3-mercaptopropionic acid | S-4 |
| Example 10 | PbS | 0.82 | $InBr_3$ | S-6 |
| Example 11 | PbS | 0.83 | $InBr_3$ | S-7 |

(continued)

| | Quantum Dots | | Ligand | Solvent |
|---|---|---|---|---|
| | Type | Band Gap (eV) | | |
| Example 12 | PbS | 0.82 | $InBr_3$ | S-8 |
| Example 13 | PbS | 0.80 | $InBr_3$ | S-9 |
| Example 14 | PbS | 0.85 | $InBr_3$ | S-10 |
| Example 15 | PbS | 0.83 | 3-mercaptopropionic acid | S-11 |
| Example 16 | PbS | 0.84 | 3-mercaptopropionic acid | S-12 |
| Example 17 | PbS | 1.34 | $InBr_3$ | S-1 |
| Example 18 | PbS | 1.31 | $InBr_3$ | S-3 |
| Example 19 | PbS | 1.31 | 3-mercaptopropionic acid | S-1 |
| Example 20 | PbS | 1.32 | $InBr_3$ | S-7 |
| Example 21 | PbS | 1.31 | $InBr_3$ | S-11 |
| Example 22 | PbS | 1.33 | $InBr_3$ | S-8 |
| Example 23 | PbS | 1.33 | 3-mercaptopropionic acid | S-6 |
| Comparative Example 1 | PbS | 0.82 | 3-mercaptopropionic acid | cS-1 |
| Comparative Example 2 | PbS | 1.34 | 3-mercaptopropionic acid | cS-1 |

[Table 2]

| | Quantum Dots | | Ligand | Solvent |
|---|---|---|---|---|
| | Type | Band Gap (eV) | | |
| Example 24 | InAs | 1.32 | $InBr_3$ | S-1 |
| Example 25 | InAs | 1.34 | $InBr_3$ | S-4 |
| Example 26 | InAs | 1.31 | 3-mercaptopropionic acid | S-2 |
| Example 27 | InAs | 1.32 | $InBr_3$ | S-6 |
| Example 28 | InAs | 1.31 | $InBr_3$ | S-7 |
| Example 29 | InAs | 1.33 | $InBr_3$ | S-11 |
| Example 30 | InAs | 1.31 | 3-mercaptopropionic acid | S-8 |
| Example 31 | InAs | 0.88 | $InBr_3$ | S-1 |
| Example 32 | InAs | 0.85 | $InBr_3$ | S-2 |
| Example 33 | InAs | 0.90 | $InBr_3$ | S-3 |
| Example 34 | InAs | 0.86 | $InBr_3$ | S-4 |
| Example 35 | InAs | 0.88 | $InBr_3$ | S-5 |
| Comparative Example 3 | InAs | 0.87 | 3-mercaptopropionic acid | cS-1 |

The materials indicated by abbreviations shown in the above tables are as follows.

[Table 3]

| Material Name | Solvent | Molecular Weight | Boiling Point (°C) |
|---|---|---|---|
| S-1 | 3-methoxy-N,N-dimethylpropanamide | 131.2 | 215 |
| S-2 | 3-butoxy-N,N-dimethylpropanamide | 173.1 | 252 |
| S-3 | dihydrolevoglucosenone | 128.1 | 226 |

(continued)

| Material Name | Solvent | Molecular Weight | Boiling Point (°C) |
|---|---|---|---|
| S-4 | 1-butylpyrrolidin-2-one | 141.2 | 155 to 157 |
| S-5 | Mixed Solvent of 3-methoxy-N,N-dimethylpropanamide and dihydrolevoglucosenone (70:30 (mass ratio)) | - | - |
| S-6 | 1-methyl-2-pyrrolidone | 99.1 | 202 |
| S-7 | 1,3-dimethyl-2-imidazolidinone | 114.2 | 225 |
| S-8 | N,N-dimethylpropanamide | 101.2 | 176 |
| S-9 | dimethylacetamide | 87.1 | 165 |
| S-10 | 1,1,3,3-tetraethylurea | 172.3 | 214 |
| S-11 | N,N-dimethylacetoacetamide | 129.2 | 220 |
| S-12 | N,N,N',N'-tetramethylmalonamide | 158.2 | 160 |
| cS-1 | toluene | 92.1 | 111 |

[Evaluation of Dispersibility]

The obtained dispersion liquid was allowed to stand at 25°C under nitrogen for 1 week or 1 month, and then the presence or absence of aggregates was visually checked to evaluate the dispersibility.

A: Aggregation was not confirmed even after being allowed to stand for 1 month.
B: Although there was slight aggregation after being allowed to stand for 1 month, no aggregation was confirmed after being allowed to stand for 1 week.
C: In the production step of the dispersion liquid, the precipitate after centrifugation separation was not dispersed.

[Evaluation of Thickness Unevenness]

100 μl of the dispersion liquid was dropped onto a 2 cm × 2 cm quartz glass, and the mixture was spin-coated at 1,000 rpm for 60 seconds and dried at 120°C for 10 minutes to form a film. The film formed on the quartz glass was divided into three parts in the vertical direction, the film thickness at the central position of each of the three divided films was measured, and the difference between the maximum film thickness value and the minimum film thickness value was defined as the thickness unevenness. The film thickness was measured using a stylus-type fine surface shape measuring device (Dektak, manufactured by Burker).

In the dispersion liquid of the comparative examples, since the film could not be formed, the thickness unevenness could not be evaluated.

[Evaluation of Dark Current and External Quantum Efficiency (EQE)]

An indium tin oxide (ITO) film having a thickness of about 100 nm was formed on a quartz glass by a sputtering method to form a first electrode. Next, a titanium oxide film having a thickness of about 20 nm was formed on the ITO film (first electrode) by a sputtering method to form an electron transport layer. Next, the step of dropping the zinc oxide nanoparticle dispersion liquid, spin-coating at 3,000 rpm, and drying at 60°C for 5 minutes was repeated twice to form a zinc oxide film having a thickness of approximately 200 nm, thereby forming an electron transport layer. The dispersion liquid described in the table below was added dropwise onto the zinc oxide film (electron transport layer) in a glove box, and then spin coating was carried out at 1,000 rpm, and dried at 120°C for 10 minutes to form a quantum dot film. The step of forming the quantum dot film was repeated 4 times to form a photoelectric conversion layer having a thickness of 180 nm. Next, the photoelectric conversion layer was dried in a glove box for 10 hours.

Next, a dichlorobenzene solution of PTB7 (poly({4,8-bis[(2-ethylhexyl)oxy]benzo[1,2-b:4,5-b']dithiophen-2,6-diyl}{3-fluoro-2-[(2-ethyl hexyl)carbonyl]thieno[3,4-b]thiophendiyl})) (concentration: 5 mg/mL) was spin-coated at 2,000 rpm onto the photoelectric conversion layer, and then dried in a glove box for 10 hours to form a hole transport layer.

Next, a Au film (second electrode) having a thickness of 100 nm was formed on the hole transport layer by a vacuum deposition method through a metal mask to manufacture a photodiode-type photodetector.

For the obtained photodetector, the current-voltage characteristics (I-V characteristics) were measured while sweeping the voltage from 0 V to -5 V in a state of not carrying out irradiation with light, and the dark current was obtained.

Here, regarding the dark current, a value at -1 V was used as the dark current.

Subsequently, the I-V characteristics were measured while sweeping the voltage from 0 V to -5 V in a state of carrying out irradiation with monochromatic light having a wavelength of 940 nm, 1,450 nm, or 1,550 nm. A value obtained by subtracting the dark current value from the current value in a state where -1 V was applied was defined as the photocurrent value, and the external quantum efficiency (EQE) was calculated from the photocurrent value. For the film having a large film thickness unevenness, the EQE at the portion having a desired film thickness was described.

For the photodetector manufactured using the dispersion liquid of Examples 17 to 30, the external quantum efficiency (EQE) was measured by emitting the monochromatic light having a wavelength of 940 nm. In addition, for the photodetector manufactured using the dispersion liquid of Examples 1 to 16 and 31 to 35, the external quantum efficiency (EQE) was measured by emitting the monochromatic light having a wavelength of 1550 nm.

In the dispersion liquid of Comparative Examples 1 to 3, since the quantum dots had poor dispersibility and the film could not be formed, the dark current and the external quantum efficiency could not be evaluated.

[Table 4]

| Dispersion Liquid | Dispersibility | Thickness Unevenness (nm) | Dark Current (A/cm$^2$) | EQE (%) |
|---|---|---|---|---|
| Example 1 | A | 9 | $1\times10^{-6}$ | 42 |
| Example 2 | A | 11 | $1\times10^{-6}$ | 45 |
| Example 3 | A | 13 | $1\times10^{-6}$ | 42 |
| Example 4 | A | 10 | $1\times10^{-6}$ | 44 |
| Example 5 | A | 19 | $1\times10^{-6}$ | 43 |
| Example 6 | A | 14 | $1\times10^{-6}$ | 40 |
| Example 7 | A | 18 | $1\times10^{-6}$ | 39 |
| Example 8 | A | 12 | $1\times10^{-6}$ | 40 |
| Example 9 | A | 13 | $1\times10^{-6}$ | 37 |
| Example 10 | B | 40 | $1\times10^{-5}$ | 41 |
| Example 11 | B | 43 | $1\times10^{-5}$ | 44 |
| Example 12 | B | 42 | $1\times10^{-5}$ | 41 |
| Example 13 | B | 39 | $1\times10^{-5}$ | 42 |
| Example 14 | B | 40 | $1\times10^{-5}$ | 43 |
| Example 15 | B | 44 | $1\times10^{-5}$ | 39 |
| Example 16 | B | 43 | $1\times10^{-5}$ | 37 |
| Example 17 | A | 11 | $1\times10^{-8}$ | 50 |
| Example 18 | A | 14 | $1\times10^{-8}$ | 49 |
| Example 19 | A | 12 | $1\times10^{-8}$ | 47 |
| Example 20 | B | 46 | $1\times10^{-5}$ | 42 |
| Example 21 | B | 40 | $1\times10^{-5}$ | 40 |
| Example 22 | B | 42 | $1\times10^{-5}$ | 42 |
| Example 23 | B | 41 | $1\times10^{-6}$ | 41 |
| Comparative Example 1 | C | Evaluation Not Possible | | |
| Comparative Example 2 | C | Evaluation Not Possible | | |

[Table 5]

| Dispersion Liquid | Dispersibility | Thickness Unevenness (nm) | Dark Current (A/cm$^2$) | EQE (%) |
|---|---|---|---|---|
| Example 24 | A | 18 | $1\times10^{-8}$ | 23 |
| Example 25 | A | 14 | $1\times10^{-8}$ | 25 |

(continued)

| Dispersion Liquid | Dispersibility | Thickness Unevenness (nm) | Dark Current ($A/cm^2$) | EQE (%) |
|---|---|---|---|---|
| Example 26 | A | 21 | $1\times10^{-9}$ | 15 |
| Example 27 | B | 39 | $1\times10^{-6}$ | 20 |
| Example 28 | B | 45 | $1\times10^{-6}$ | 19 |
| Example 29 | B | 47 | $1\times10^{-6}$ | 21 |
| Example 30 | B | 48 | $1\times10^{-7}$ | 12 |
| Example 31 | A | 10 | $1\times10^{-6}$ | 3.0 |
| Example 32 | A | 16 | $1\times10^{-6}$ | 2.9 |
| Example 33 | A | 14 | $1\times10^{-6}$ | 3.4 |
| Example 34 | A | 9 | $1\times10^{-6}$ | 3.2 |
| Example 35 | A | 13 | $1\times10^{-6}$ | 2.5 |
| Comparative Example 3 | C | Evaluation Not Possible | | |

As shown in the table above, the dispersion liquid of Examples had excellent dispersibility. In addition, the thickness unevenness was 50 nm or less, and a quantum dot film having a small thickness unevenness could be formed. Furthermore, a photodetector having a small dark current and a high external quantum efficiency (EQE) could be obtained. In the InAs quantum dot having a small band gap, the external quantum efficiency (EQE) of 2.5% or more is a high value.

In a case of manufacturing an image sensor using the photodetector obtained in Examples by using an optical filter produced according to the method described in WO2016/186050A and WO2016/190162A and together with a publicly known method, it is possible to obtain an image sensor having good visibility and infrared imaging performance.

Explanation of References

1: photodetector

11: first electrode

12: second electrode

13: photoelectric conversion layer

21: electron transport layer

22: hole transport layer

## Claims

**1.** A dispersion liquid comprising:

quantum dots;
a ligand; and
a solvent,
wherein the solvent includes at least one selected from a compound represented by Formula (1) or a polycyclic ketone compound, and
a content of the quantum dots in a component obtained by removing the solvent and the ligand from the dispersion liquid is 50% by mass or more,

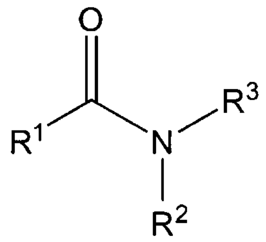

(1)

in Formula (1), $R^1$ represents a hydrogen atom or a substituent having 1 to 10 carbon atoms,
$R^2$ and $R^3$ each independently represent a hydrogen atom or a substituent having 1 to 10 carbon atoms, and two or more of $R^1$, $R^2$, and $R^3$ may be bonded to each other to form a ring structure,
where, in a case where $R^1$ is a hydrogen atom, at least one of $R^2$ or $R^3$ is a substituent having 2 or more carbon atoms.

**2.** The dispersion liquid according to claim 1,
wherein the solvent includes the compound represented by Formula (1), and $R^1$ in Formula (1) is a substituent having 2 to 10 carbon atoms and including an ether bond.

**3.** The dispersion liquid according to claim 1,

wherein the solvent includes the compound represented by Formula (1), and $R^1$ in Formula (1) is a group represented by Formula (R-1),

$-R^{11}-R^{12}\cdots$ (R-1),

in Formula (R-1), $R^{11}$ represents an alkylene group, $R^{12}$ represents an alkoxy group, and the total number of carbon atoms in $R^{11}$ and $R^{12}$ is 2 to 10.

**4.** The dispersion liquid according to claim 1,
wherein the solvent includes the compound represented by Formula (1), and $R^1$ and $R^2$ in Formula (1) are bonded to each other to form a ring structure.

**5.** The dispersion liquid according to claim 1,
wherein the solvent includes the polycyclic ketone compound, and the polycyclic ketone compound includes a 5- to 7-membered ring structure having an oxygen atom as an atom constituting a ring.

**6.** The dispersion liquid according to claim 1,
wherein the solvent includes at least one selected from 3-methoxy-N,N-dimethylpropanamide, 3-butoxy-N,N-dimethylpropanamide, dihydrolevoglucosenone, or 1-butylpyrrolidin-2-one.

**7.** The dispersion liquid according to any one of claims 1 to 6,
wherein a content of the quantum dots in the component obtained by removing the solvent and the ligand from the dispersion liquid is 90% by mass or more.

**8.** The dispersion liquid according to any one of claims 1 to 6,
wherein the quantum dots contain at least one atom selected from Ga, Ge, P, As, Se, In, Sn, Sb, Te, Pb, Bi, Ag, Cu, or Hg.

**9.** The dispersion liquid according to any one of claims 1 to 6,
wherein the quantum dots contain at least one atom selected from P, As, Sb, or In.

**10.** The dispersion liquid according to any one of claims 1 to 6,
wherein the quantum dots have a band gap of 1.35 eV or less.

**11.** The dispersion liquid according to any one of claims 1 to 6,
wherein the quantum dots have a maximal absorption in terms of absorbance in a wavelength range of 900 to 1,700 nm.

**12.** The dispersion liquid according to any one of claims 1 to 6, wherein the ligand includes at least one selected from an inorganic ligand or a compound having 7 or less carbon atoms.

**13.** A method for manufacturing a quantum dot film, comprising:

applying the dispersion liquid according to any one of claims 1 to 6 onto a support to form a composition layer; and drying the composition layer.

**14.** A method for manufacturing a photodetector, comprising: performing the method for manufacturing a quantum dot film according to claim 13.

**15.** A method for manufacturing an image sensor, comprising: performing the method for manufacturing a quantum dot film according to claim 13.

FIG. 1

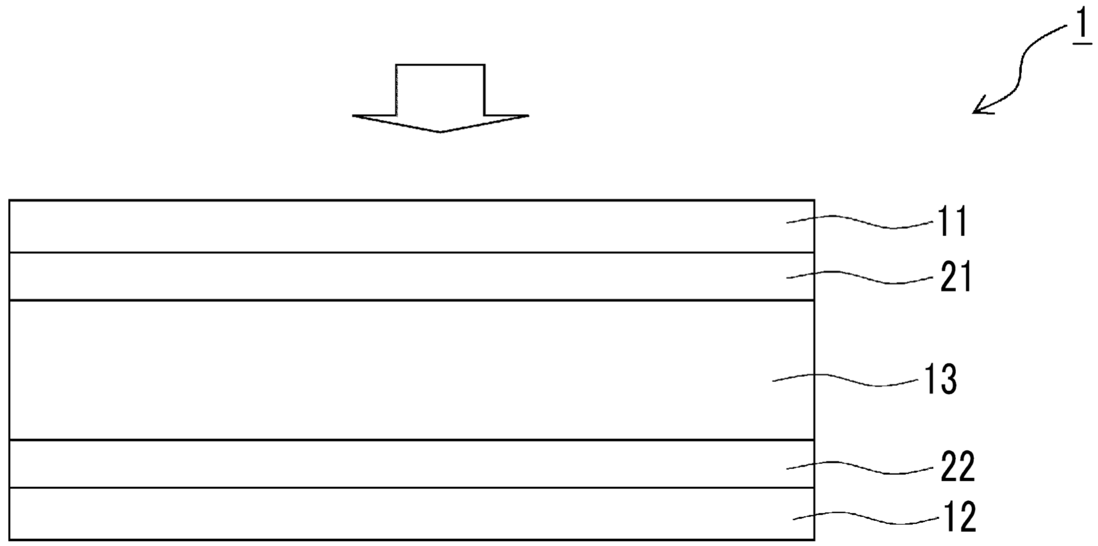

## INTERNATIONAL SEARCH REPORT

International application No.
**PCT/JP2024/023471**

### A. CLASSIFICATION OF SUBJECT MATTER

***H10K 30/60***(2023.01)i; ***H01L 27/146***(2006.01)i; ***H10K 30/40***(2023.01)i; ***H10K 39/32***(2023.01)i
FI: H10K30/60; H10K39/32; H01L27/146 C; H10K30/40

According to International Patent Classification (IPC) or to both national classification and IPC

### B. FIELDS SEARCHED

Minimum documentation searched (classification system followed by classification symbols)

H10K30/60; H01L27/146; H10K30/40; H10K39/32

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2021-128342 A (DONGWOO FINE-CHEM CO., LTD.) 02 September 2021 (2021-09-02) claims 1-2, 14, paragraphs [0025], [0028], [0105]-[0108], [0165]-[0176] | 1-2, 4-5, 8-10, 12-13 |
| Y | | 2-3, 6, 11 |
| A | | 7, 14-15 |
| Y | JP 2019-112575 A (TOYO INK SC HOLDINGS CO., LTD.) 11 July 2019 (2019-07-11) paragraphs [0086], [0098]-[0100], [0123] | 2-3, 6 |
| Y | WO 2021/070858 A1 (NS MATERIALS INC.) 15 April 2021 (2021-04-15) paragraphs [0001]-[0032] | 11 |
| A | WO 2021/251309 A1 (FUJIFILM CORPORATION) 16 December 2021 (2021-12-16) entire text, all drawings | 1-15 |
| A | WO 2021/112072 A1 (KAO CORPORATION) 10 June 2021 (2021-06-10) entire text, all drawings | 1-15 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 July 2024** | **30 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/023471**

| Patent document cited in search report | Publication date (day/month/year) | Patent family member(s) | Publication date (day/month/year) |
| --- | --- | --- | --- |
| JP 2021-128342 A | 02 September 2021 | KR 10-2021-0102841 A | |
| | | CN 113248953 A | |
| JP 2019-112575 A | 11 July 2019 | (Family: none) | |
| WO 2021/070858 A1 | 15 April 2021 | TW 202122341 A | |
| WO 2021/251309 A1 | 16 December 2021 | US 2023/0105965 A1 | |
| | | KR 10-2023-0002773 A | |
| | | CN 115699337 A | |
| WO 2021/112072 A1 | 10 June 2021 | US 2023/0006148 A1 | |
| | | CN 114788031 A | |
| | | KR 10-2022-0107206 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020150251 A
- JP 5949567 B
- JP 2001291534 A
- JP 2013077009 A
- JP 2014130173 A
- JP 2014130338 A
- WO 2015166779 A
- WO 2016178346 A
- WO 2016190162 A
- WO 2018016232 A
- JP 2016177079 A
- JP 2014130332 A
- WO 2016027798 A
- WO 2016186050 A
- WO 2016035695 A
- JP 6248945 B
- WO 2019021767 A
- JP 2017067963 A
- JP 6506529 B
- JP 2014130344 A
- JP 2018010296 A
- WO 2019039172 A
- WO 2019017280 A
- WO 2018092600 A